# EUROPEAN PATENT APPLICATION

(11) **EP 1 437 849 A1**
(43) Date of publication of application: **14.07.2004**
(21) Application number: 02772427.7
(22) Date of filing: 27.09.2002
(51) Int. Cl.: H04H 1/00, H03J 9/02

(54) **SYSTEM OF EMITTERS AND REMOTELY-CONFIGURABLE DEVICES THAT ARE USED TO CAPTURE A RADIO AUDIENCE AND TO ESTABLISH LOYALTY IN RELATION TO SAID AUDIENCE**

(30) Priority: 28.09.2001 ES 200102187
(71) Applicant: Global Standards, S.L., 28224 Madrid (ES)
(72) Inventor: MARCOS ALBA, Fernando, E-28224 Madrid (ES)
(86) International application number: PCT/ES2002/000456
(87) International publication number: WO 2003/030417

(57) **Abstract**

The invention relates to a system comprising a control centre (45), a network of master emitters (60) and a park of radio broadcasting receivers (30) which are remotely configured. The control centre (45) send the master emitters (60), via any means such a the Internet (46), encoded digital information which is combined with the signals peculiar to the emitters and which is sent from the emitters to the receivers (30). The aforementioned digital information contains configuration information for the receivers (30) as well as other data. The configuration information is used to assign broadcast tuning to the channels of each receiver (30), said channels being enabled to listen to determined frequencies corresponding to the radio broadcasting emitters operating in the environment of the receiver (30). The rest of the digital information is intended to be viewed on a display device (24) of the receiver (30). The receivers (30) receive said encoded digital information in a continuous manner.

## Description

System in which an operator rules a control station, a set of radio broadcasting transmitters, a set of master broadcast stations and a set of remotely configurable receivers. Each transmitter sends digital data to the receivers, by means of any technical procedure known in the state of the art, such as the RDS System. These digital data is decoded and interpreted in each receiver. Part of this data is used for sending the receiver's configuration, i.e., the tuning frequency corresponding to each channel of the receiver.

**Technical Sector**.- The System is formed by several transmitters and a plurality of specialized receivers. Therefore it falls into the area of telecommunication appliances.

### State of the Art.-

### Part I: Receivers.-

Today's scene of mass media and broadcasting stations in particular in most of the countries in which these media are much developed is that of a strong competition to enlarge their respective audience. Competition in this sense is measured, in absolute terms, by the number of listeners whereas, in relative terms, it depends on the audience quota of listeners, audience share or simply "share", which provide us with the percentage of radio listeners who at a given span of time listen to a special radio station, compared to the total of listeners who are listening to any radio station during the same span of time (or a smaller group of listeners in the case of specialized channels). Broadcasters try to enlarge their audience share as much as they can, since their benefits from advertising spots strongly depend on the said quota. Likewise their social importance becomes more relevant. On the other hand, as listeners are free to tune whatever radio station they fancy to listen to, broadcasters are permanently interested to find out their listeners' likings to fit their programmes accordingly.

Thus, broadcasters spend large efforts to get a better knowledge of their respective audience so as to meet with their requirements as best as they can. Broadcasters are constantly trying to better their programming by offering new and original productions to their regular listeners, to the listeners of other radio stations as well as to casual radio listeners.

At present, the question of how to draw in more radio listeners and make them remain attached to a particular radio station is based on sociological issues and the solutions searched for to this problem lie on the same outlook.

A different approach based on technical issues is proposed to the problem of growing up and generate loyalty to a given radio-station.

The existing radio receivers always come with a tuning control intended for choosing and changing among different radio stations/chains. They are universal receivers, and from the point of view of broadcasters they **lack selectivity**. Their **addressees** are the radio listeners, and their function is to let them tune any radio station/chain. The audience due to them is the natural audience of the radio station/chain, i.e., the audience derived from the listener's satisfaction due to the programs received. Existing radio receivers are not useful for the objective of enlarging and make the radio audience remain faithful to a given radio station/chain.

Radio receivers intended for commercial broadcasting have been developed under a design philosophy in which the receiver can be tuned to any possible frequency (each frequency corresponding to the reception of a given radio station/chain). This is a deeply rooted philosophy in the radio design technique, so that radio designers haven't considered alternative scenario regarding this question.

This established scenario can be understood as a consequence of the user's interest in receiving the signals of different radio stations/chains with a single device.

But that scenario is not the unique one possible. A more general scenario can be considered where a receiver is conceived for satisfying the needs of third parties that may be other than the user of the receiver.

This generalization appears once a conception prejudice or model prejudice - implicitly assumed by commercial broadcasting radio receiver manufacturers and designers - is overcome.

In the established scenario, the receiver has been conceived for the satisfaction of the needs of the receiver's user. As there is a large variety in radio stations/chains, an indefinite communication channel arises between radio stations and users.

But another particular case can be considered inside the generalized scenario, which is dual for the established scenario. In this case the addressee of the device would be a broadcaster. Its needs are different from that of the radio listener, and could be focused in establishing a defined communication channel with the largest possible number of radio listeners.

The aforementioned concepts can be joined in the following table:

| | **Receiver designed for satisfaction the needs of:** | **Type of needs** | **Type of communication channel established between a given station and a user** |
|---|---|---|---|
| **Generalized scenario** | A given customer | Undetermined | Undetermined |
| **Established scenario** | Radio listener | Reception of Programmes | Undefined |
| **Proposed invention** | Operator of the proposed System | Growing up and generate loyalty to the associated stations | Definite among a predetermined offer. There is a data channel to which the receiver stays permanently tuned |

Application PCT/ES99/00372 (of the same applicant than this one) introduces several embodiments for solving this problem, which were named: Radio Audience loyalty-generating and pick-up Device. The simplest embodiment of this device is a radio receiver in which tune frequency has been properly fixed to a predetermined value. From the point of view of broadcasters, the **selectivity** of a pretuned loyalty-generating and pick-up device is complete, meaning that, in case the device is used, a unique signal can be obtained: that corresponding to the frequency to which it is pretuned to. In contrast with the universal receiver, the natural **addressee** for the device is a broadcaster. The **function** of the device is different to that of the universal receiver, because when used it will tune to a unique frequency. Thus, the device may be a very useful tool for enlarging and make the audience remain faithful to a given radio station/chain.

Another embodiments described in said application PCT/ES99/00372 are devices capable for receiving a reduced number of tuning frequencies, in order to allow listening, for example, the programmes of two associated stations/chains which may be transmitting complementary programmes, thus not being competitive in the sense referred to in the introduction (for example a station/chain specialized in news and another station/chain specialized in music programmes).

The Radio Audience loyalty-generating and pick-up Devices described in the said application have got a limitation: the radio stations/chains that can be tuned have been fixed in origin, and the selection of that particular subset of tunes gets fixed when the receivers are manufactured, and it cannot be changed afterwards. In the most complex embodiments of the application it is claimed that the same device may tune the different frequencies used by a radio chain, thanks to the use of some codes (such as those given by the RDS system), thus achieving portability for the device, so that it can be useful inside all the coverage area of the radio chain. However, the permanent predetermination of the stations/chains limits the possibilities of the device as a source of satisfaction for their users, consequently limiting its potential commercial success.

### Part II: Techniques for broadcasting data (digital information).-

Several techniques have been developed for inserting digital information into frequency modulated transmissions. There are even some systems for sending data with medium wave transmitters, though they are not relevant, since there is not much bandwidth available. Most of these techniques are based in the addition of a subcarrier, which is used for injecting signals that have been modulated by digital signals using an adequate modulation technique for the subsequent hertzian transmission.

The most popular technique is the RDS system (developed in Europe) or RDBS (very similar to RDS, but adapted to the peculiarities of the USA). In this system the data band is injected around a subcarrier of 57 kHz, taking advantage of part of the spectrum assigned to each station/chain which is not used by the audio signal. The additional data is intended for sending codes. These codes are useful for identifying each station, each program, the kind of program, etc., as much as for sending useful information regarding traffic, road accidents, synchronism signals, etc. This data can be recovered using specific decoders that are available even as integrated circuits.

RDS/RBDS systems allow switching between frequencies that are in use for the same programs, the so called alternative frequencies, or AF. Switching can be performed automatically, attending to the signal level of each alternative frequency detected by the receiver all the time. This property has been one of the most attractive figures offered by RDS/RBDS systems, and was specially developed for automotive receivers. Because of their movement, it may happen the program being listened gets a better signal on an alternative frequency allocated for the actual place. In general (also for non automotive applications) these systems allow tuning to the best possible signal owned by any alternative frequency assigned to a given radio chain.

With a similar scope can be mentioned the DARC system (Data Radio Channel, formerly known as SWIFT), which was initially developed by the Japanese company NHK. This technique allows the injection of a gross bitrate of 16 kbps, nearly fifteen times the bitrate of the RDS system. DARC system is based in a subcarrier of 76 kHz and a dynamic modulation technique called LMSK (Level Minimum Shift Keying). There are other systems known in the State of the Art: HSDS (using a subcarrier at 66.5 kHz and a bitrate of 19 kbps) and STIC (using a subcarrier at 72.2 kHz and a bitrate of 7.6 kbps). These three techniques are compatible with the RDS subcarrier, so that it is possible to send data by RDS and by anyone of the said subcarriers at a time. Although these other systems are scarcely used if compared to RDS, all of them provide a much larger bitrate without interfering the audio signal. They have been included in the international recommendation ITU-R: BS.1194-1.

### Part III: Consequences of Part I over the data channel.-

As it has been explained in Part I, commercial radio receivers are universal receivers, in the sense that the user can listen to any station of one or more radio bands. Accordingly the existing systems for data transmission have been conceived assuming that the user will often change from one station to another. Consequently, all the information must be sent very frequently, especially those functions intended for being a help when tuning the receiver. For example: RDS system enforces a continuous repetition (this means 11,4 times per second) of some data, such as the PI, PTY, TP, and a very frequent repetition of 4 times per second of other data such as PS, AF, TA, MS. This large repetition rate ensures a maximum delay time of 2 seconds for showing the station name on the display when sweeping around dial in ideal conditions, or 4 seconds in mean receiving conditions. Considering that the net bitrate of RDS cannot be larger than 673.7 bps (from a gross bitrate of 1187.5 bps), the above mentioned functions consume 57.7% of the useful data channel. This leads to a quite remarkable conclusion: as far as the receiver has been conceived trying to satisfy the user's needs, the largest part of the useful bandwidth of the data channel must be dedicated to a very frequent repetition of very small pieces of data.

### Part IV: RDS System.-

Due to the length of the Standard and to the amount of details contained in it, the interested reader is kindly addressed to specific texts or the Standard itself (CENELEC, EN 50067). (The RDS Standard is available at the following Internet site: http://www.rds.org.uk). This is an abstract of what is required for describing the present invention:

In the RDS system information is structured by means of the so called groups, which can be of 32 different types, numbered form 0A, 0B to 15A, 15B. Data is sent at a constant bitrate of 1187,5 bps (= 57K/48). This dataflow contains the said groups, each one composed of 104 bits. The groups are repeated at different rates, depending of its relevance, their character (static/dynamic) and also depending on the broadcaster criteria. The broadcaster is encouraged to comply with certain limits defined in the Standard.

The following services have been referred to when describing this invention, thus they are briefly explained below:
**CT** = "Clock Time and date", group 4A as defined in the Standard. This group is intended for sending the time using the UTC standard (Universal Time Coordinated), as much as the offset due to local time and the Julian modified date. Broadcasters employing this service have to send a group 4A each time the seconds move form 59 to 00, i.e., each time the minute value is changed.
**PIN** = "Programme Item Number", groups 1A or 1B as defined in the Standard (group 14 for some applications). This group is intended for assigning a unique code to each programme, based in the time of beginning of the programme (which is formed by the day of the month, the hour of the day and the minute at which the programme is scheduled to begin). Even though the schedule is frequently altered, this simple rule allows defining a unique code. What is really important for this group for being useful is to send the right PIN when the coded programme really begins. This service is intended for automatic recording of programmes: the listener can read in the newspaper or in the station's programming guide the date, hour and minute scheduled for beginning and form the PIN code by itself. The receiver can then be programmed with the PIN code and it will activate a recorder device when the received PIN matches the programmed value, thus synchronizing the real time of beginning and ending of the programme.
**PI** = "Programme Identification", this information is included in all the groups, due to its importance. This is a code used as a univocal identity for each radio programme. It is formed by 16 bits, structured as follows: the first 4 bits refer to the country, the second 4 bits specify supranational, national, regional or local programming, and the remaining 8 bits identify the programme. When a national chain switches to local programming the second nibble is changed. The correct use of this code is essential to avoid malfunctions in some services of the RDS system. These codes are assigned by public organizations in Europe. Due to its importance the assignation of PI codes and its subsequent observance belong to the normative part of the Standard.
**ODA** = "Open Data Applications". When the RDS system was launched, a new group was assigned to each new service. But as the number of available groups is very limited, a special type of groups was created, called ODA. ODA allows the creation of a huge number of specific applications based on RDS, being public or private. For using an ODA application a broadcaster begins sending a 3A group, as a declaration for all the RDS receivers. This group must be repeated once a minute and it contains:
   - 16 bits for a code identifying the application (AID = "Application IDentification").
   - 5 bits for reporting the groups that are going to be used for the information
   - 16 bits that can be used for sending application-related information.
Light applications can be embedded into the last 16 bits of the 3A group. Otherwise, the referred 5 bits specify the groups that are to be used for sending the information among the following: 3B, 4B, 7B, 8B, 9B, 10B, 11A, 11B, 12A, 12B, 13B. There are another 8 groups that can be used for ODA applications, provided the broadcaster is not using the following services: TDC, IH, RP, TMC o EWS. This coding scheme makes possible for two stations of the same chain to send the same application using different groups, thus allowing the use of a TDC to one of the two stations.

The target receivers of a specific application must be able to acknowledge the corresponding AID code and decode it.

The AID code must be formally requested to the EBU (European Broadcasters Union) in Europe or to the NAB (National Broadcasters Association) in North America. This procedure ensures the required coordination and interoperability among RDS enabled receivers. Nowadays there are still about 65.000 codes available.

### Part V.- Digital broadcasting.-

During last years several novel broadcasting systems based on digital techniques have been developed, which are known as DAB (Digital-Audio-Broadcasting). European system known as Eureka-147 was adopted by the ETSI as an international standard during 1.995 and is considered the most advanced system proposed. According to this system, the radio signal that is going to be transmitted is firstly digitized and then compressed regarding the psychoacoustics characteristics of human hearing (using the so called MPEG or MUSICAM (Masking-Pattem-Adapted-Universal-Subband-Integrated-Codding-and-Multiplexing) technique. Before transmitting the signals an information multiplex is composed, using several signals each one corresponding to a single broadcast. The multiplex contains information that has been mixed in time and frequency domains by means of a technique called COFDM (Coded-Orthogonal-Frequency-Division-Multiplex). The information must be successively processed in order to optimize the energy that will be radiated by the station. Also, the information that is going to be transmitted is reinforced using redundancy techniques and subsequent error correction in the receiver. Information can be broadcasted from terrestrial stations (the so called T-DAB), by cable (C-DAB) or directly by satellite (S-DAB). From the user's point of view digital radio broadcasting means very high quality sound (equivalent to that of a Compact-Disc) and interference-free signal reception. Also, there is a possibility of sending data and low resolution video at a time. Additional information is sent for each program, the so called PAD ("Program-Associated-Data").

There are other systems. Among them should be distinguished that proposed by the American consortium WorldSpace, and the IBOC (In-Band-On-Channel) and IBAC (In-Band-Adjacent-Channel) systems. The first one is based on a very similar technology to that described for the Eureka-147 (relying upon intensive digital signal processing). The IBOC and IBAC systems work over the AM and FM bands, so that they can be adopted with the existing frequency allocation; digital radio broadcasting in the United States will follow this way. In these last systems, tuning can be performed as in conventional receivers. Then analog to digital conversion is performed, then digital signal processing, and last, digital to analog conversion and further amplification for driving the speakers.

### Part VI: Radio offer.-

Nowadays there are too many transmitters especially in the FM band in urban areas. As far as they usually compete for the same market, their programmes tend to be similar, lowering the quality of the offer, understood as a whole. The best example of it happens when there is an important football competition, since most operators use to broadcast it, neglecting their regular programming style, thus reducing the offer to a very limited scope. The listener cannot enjoy the radio when the dial expands chaotically and without a well conceived plan, making difficult to pick up new listeners or even maintain the existing listeners.

### Part VII.-Relation between radio and time.-

The radio lives in a permanent present, in contrast with the written media. Accordingly, the programmes must include frequent repetitions, which implies a waste of time, and bores heavy listeners. For example, many stations transmit a news bulletin each hour. Moreover, if something important happens, it must be incessantly explained and periodically summed-up, in order to introduce the facts to the listeners that have just joined up.

### Part VIII.- Techniques for sending digital data using mobile telephones.-

Digital cellular phones of any standard (GSM, WAP, GPRS, UMTS, TDMA, CDMA, W-CDMA, etc.) may interchange data among them. For example the SMS (Short Message Service in GSM standard) for sending text messages, or even graphic screens, as the multimedia MMS (Multimedia Message Service using the GPRS standard over GSM). However the telephonic systems have been conceived for interchanging information on a one to one basis. In fact, the reference application is the provision of means for making possible conversations at unlimited distance, which gives the name to these systems. These technologies haven't been conceived for releasing information to many people at a time, since this is the purpose of multicast or broadcast technologies. There is a special transmission mode called cell broadcast in the GSM Standard for cellular telecommunications. Cell broadcast simplifies the protocol for sending information, compared with that used for sending SMS messages, allowing the reception of some messages to any subscriber in a cell, provided its mobile phone is on. The above mentioned standards provide means for entering in specific Internet portals, thus accessing to huge amounts of information, but this service must be paid for, and this limits the interest of the users.

### Explanation of the invention:

Now is introduced a System that maintains some points in common with the invention explained in application PCT/ES99/00372, but greatly improving its possibilities and performances.

This System complies, on one side, a set of specialized receivers that are distributed around several regions, and on the other side, a set of broadcasting transmitters covering each of the mentioned regions. The System is controlled by an operator from a control centre (45), who sends digital data to the said receivers through a second set of transmitters, called master broadcast stations. The master broadcast stations can be radio broadcasting transmitters or even other kind of transmitters.

The most relevant feature of the receivers is that they include a control key intended for selecting channels. Each channel provides an audio programme. For example, channel 1 can be dedicated to a general purpose programme, channel 2 can be dedicated to sports programme, channel 3 to music novelties programme, and channel 4 to popular music programme. Two types of channels have been considered: simple channels and compound channels. Simple channels correspond to a radio frequency during time (without interruptions). They can be represented by a table like this one:

**TABLE 1**

| **CHANNEL** | **BAND** | **FREQUENCY** |
|---|---|---|
| channel a1 | FM | fa1 |
| channel a2 | SW | fa2 |
| channel a3 | AM | fa3 |
| channel a4 | UHF (TV) | fa4 |
| ... | ... | ... |
| channel aa | DAB | faa |

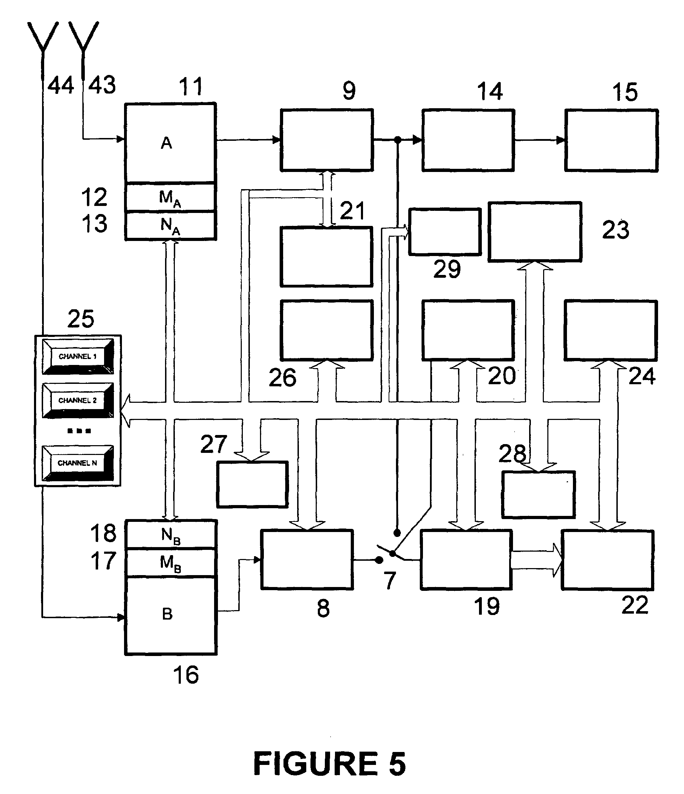

In table 1 there are found radio channels in the frequency modulated band (channel a1), short wave band (channel a2), medium wave band (channel a3), the sound of TV channels (channel a4), and digital audio broadcast band (channel aa). For example, if the listener selects *channel a1,* then the controller (20), figure 5, of the receiver will search the configuration table (contained in memory) and will find all the information needed for tuning the receiver to frequency fₐ₁, including the frequency band to which it belongs (FM, in this example). Accordingly, the controller will change the required controls in order the receiver get tuned to that frequency (for example, figure 5, the frequency dividers N_{A} (13) and M_{A} (12) of the PLL loop of tuner A (11), the antenna (43), the radiofrequency amplifier, the intermediate frequency amplifier, the demodulation section (9), etc.). To simplify the writing, we will call "tuning controls" onwards to all the elements commanded by the controller (20) that determine the tune heard in a given moment.

On the other hand, the compound channels correspond to different frequencies depending on time. They can be represented by a table as this one:

**TABLE 2**

| CHANNEL | BAND | FREQUENCY | DAY of WEEK | BEGIN TIME | END TIME |
|---|---|---|---|---|---|
| channel b1 | AM | fb1,1 | M,W,F | 00.00 | 24.00 |
| | FM | fb1,2 | T,Th,S | 00.00 | 24.00 |
| | AM | fb1,3 | Su | 00.00 | 24.00 |
| channel b2 | SW | fb2,1 | M to Su | 00.00 | 9.00 |
| | SW | fb2,2 | M to Su | 9.00 | 12.00 |
| | FM | fb2,3 | M to Su | 12.00 | 24.00 |
| ... | ... | ... | ... | ... | ... |
| channel bb | LW | fbb,1 | M to F | 00.00 | 15.00 |
| | FM | fbb,2 | M to F | 16.00 | 24.00 |
| | UHF(TV) | fbb,3 | M to Su | 15.00 | 16.00 |
| | AM | fbb,4 | S,Su | 00.00 | 15.00 |
| | DAB | fbb,5 | S,Su | 16.00 | 24.00 |

For example, if a listener selects *channel bb* on Monday at 14.55, then the receiver's controller will firstly read time on the real time clock, then it will find all the required information in the configuration table (depending on time and date) for tuning the receiver to frequency f_{bb,1}, including the frequency band to which the frequency belongs to (LW in this example). Accordingly, the controller will command the "tuning controls" (see page 9) in order the receiver gets tuned to that frequency. If the listener is still tuned to *channel bb* when the real time clock arrives to 15.00, then the receiver will tune to frequency f_{bb,3} which belongs to the UHF (TV) band for providing the audio signal of a TV channel, once the receiver's controller have commanded the tuning controls automatically (without intervention of the listener).

On the other side the operator of the System controls the master broadcast stations. The operator acts as a contents manager, since he determines which tune (or tunes) correspond to each channel of the receivers (30) for each of the regions in which the System is in operation.

The operator of the System uses a hertzian communication channel for sending digital information to the receivers. Part of this information is the said configuration information (i.e., the information required for enabling a tune in a channel of the receiver), which will be stored in the memory of each receiver, making possible to determine anytime the frequency and band corresponding to each channel. The data channel can also be used for sending other useful data; for example: last news, weather conditions, etc. This information will be shown on a display that will be part of each receiver.

Each receiver contains two independent tuners: one of them will stay permanently tuned to the master frequency, whereas the other one will be tuned to the frequency determined by the channel selector. The permanent link with the master frequency leads to a more efficient use of the data channel. In Part III of the State of the Art it was explained that nowadays those broadcasters sending data must use very high repetition rates, just in case the listener is changing the station, in order to refresh the newly tuned frequency as soon as possible in the receiver's memory. Conversely, as far as the receivers described in the present invention stay permanently tuned to the data channel of the master broadcast station, the repetition rates can be lowered to reach a compromise between the existing set of receivers (which need a high repetition rate) and the exploitation of the data channel for sending much more data for the set of receivers manufactured in accordance with the present invention.

Another improvement due to the permanent link to the data channel is explained as follows. Everybody knows that there is a lack of past in the radio. Information, especially news bulletins, must be frequently repeated, as it was explained in Part VII of the State of the Art. These repetitions impedes for making the most of the audio channel, being in effect all the time dedicated to repetitions lost time. However, if the tuner dedicated to data stays always on (even when the listener turns off the tuner dedicated to audio, since he doesn't want to listen radio any more -see the description of the operation modes below) the receiver will stay receiving data. This information will be stored in the memory. Accordingly the receiver will always be updated and the radio will gain the missing past for the informative facet. Broadcasters associated to this System will benefit from this fact, reducing the repetition rates of the news bulletins, provided a great deal of listeners will use a receiver as such described in the present invention.

The information received through the data channel will be structured in order to simplify browsing around it using a key buttons or an equivalent knob (29) and a display.

Besides the configuration information, which is addressed to all the users of the System in each covered region, the remaining information belongs to one of the following groups:
1. Common information, which is addressed to all the users of the System in a region.
2. Group information, which is addressed to a group of users of the System.
3. Personal information, which is addressed to a unique receiver in the whole System.

In spite of all the information being radiated at a time, each receiver only shows some parts of that information. This segmentation of the information is really useful, since it allows the operator of the System to efficiently direct the messages to different targets. For example, it makes possible to send the results of the football pools just to the group of users interested in sports information.

Many techniques have been developed for sending digital data through wireless systems, as it was explained in Part II of the State of the Art. For broadcasting systems, most developments are intended for the frequency modulated band, since each broadcaster exploits a 100 kHz bandwidth, making possible the transmission of stereo signals with a bandwidth of about 15 kHz (which is enough for most human ears) as much as one or more data subcarriers, such as RDS, DARC, HSDS or STIC.

For recovering the digital data in the receiver, a bandpass filter centred at the corresponding subcarrier frequency must be used. The filter must be fed with the demodulated audio signal. The filter output must be decoded with a specific decoder, which depends on the data subcarrier used. The decoder output is the original digital dataflow send by the transmitter, usually degraded to some extent due to the radio transmission. This dataflow is generally formed by useful data bits and other bits used for error detection or correction. For all the data subcarrier systems mentioned before there are commercial integrated circuits. These circuits perform all the required functions, from filtering to error detection/correction.

Figure 5 represents a block diagram of the receiver: tuner A (11) could be dedicated to recovering the audio signal (and its circuits might be specialized accordingly) whereas tuner B (16) could be dedicated to recovering the data signal (its circuits might also be specialized). This scheme makes possible a better exploitation of the data channel and a rate for updating information that would not depend on the audio channel selected by the listener, who might or might not tune the master frequency.

Other radio techniques can be used for creating a data channel, depending on the criteria ruling the project: budget, coverage area or other criteria. For example: digital radio DAB allows simultaneous transmission of audio and data, and the same can be said of the American digital radio IBOC/IBAC, sending data over the plain old AM/FM bands.

The System explained in the precedent pages allows offering to the radio listener a well planned channel selection in which the programmes may be complementary from one to each other. It may also be of help for founding quality programmes in saturated dials. It is a contribution for reducing listeners scattering among programmes of very different relevance. Last, since the frequencies assigned to channels can be easily changed, the System itself might be helpful for the operator of the System when negotiating the conditions for enabling certain frequencies as much as either their maintenance in time or their replacement for another more attractive frequencies. The System can be a valuable tool for picking up new listeners for the stations/chains included in the Channel Offer of the System, as much as for generating loyalty among these listeners, if properly used.

Though the teleconfigurable receiver may host a large Channel Offer, it makes sense to include conventional tuning controls for tuner A (11). This way the device would be also useful for passionate listeners of other chains not included in the Channel Offer of the System. The device will still preserve two interesting properties for the System's operator: passionate listeners of chains not included in the Channel Offer of the System would be frequently incited to try the Channel Offer of the System. Additionally, they will always maintain a link with the System's data channel through tuner B (16) and display (24).

To make possible for the System's operator to know the success of each teleconfigured channel and the usefulness of each information menu offered through the display (24), receivers (30) can be easily evolved for monitoring the listeners' patterns of use. A small part of the set of receivers (30) should include a program for performing audimetric functions and a subsystem (28) for sending these registers to the control centre (45) of the System using the public telephone system. The program must register the listener's exposure to the audio media and the also its exposure to the visual media.

For this audimetric technique to be useful, a group of listeners should be found which must be a valid sample from a statistical point of view.

The display (24) can be an attraction for the user by its own, enlarging the total amount of time spent by the listener with the receiver (30); sometimes the user will pay attention to the sound reinforced by messages shown on the display, whereas in other circumstances the sound may disturb (for example, at work). For this reason the receiver (30) should have got 3 operation modes: Mode 1, in which all circuits of the receiver are active, Mode 2, in which all stages related with the production of sound signals are disabled, and Mode 3, in which only remain enabled those circuits involved on recovering and processing the information received through the data channel.

The continuous operation of the data channel should help to enrich the radio experience, thus increasing the loyalty of the listeners. Some other elements should also be helpful:
- Alert commands: They are intended to warn listeners whose receivers (30) are not active when important events take place. Accordingly, the listener will move to the radio media not only when he desires it, but also when he is warned about from the control centre (45), thus augmenting the possibilities of interaction of the radio media with its audience.

The alert commands are organized as follows:

**TABLE 3**

| **Receiver's (30) MODE before reception of an alert command** | **Command Type** | **Receiver's (30) MODE after reception of an alert command** |
|---|---|---|
| Mode 1 (audio and visual) | Command Type I | No change |
| | Command Type II | |
| Mode 2 (only visual) | Command Type I | Change to Mode 1 |
| | Command Type II | No change |
| Mode 3 (only receiving data) | Command Type I | Change to Mode 1 |
| | Command Type II | Change to Mode 2 |
| Any Operation Mode | Return Command | Restores the current Operation Mode before receiving an alert command |

Besides Types I or II described heretofore, there are several warning levels for alert commands, for example:

**TABLE 4**

| **Warning levels** | **Meaning** |
|---|---|
| High (A) | The event probably affects the listener |
| Medium (M) | The event probably interests the listener |
| Low (B) | The event probably worries the listener |

The transitions between Operation Modes referred in table 3 will take place only if the listener has enabled this possibility in the receiver (30), since remotely commanded transitions might be intrusive or even bothering. Accordingly there is a personal configuration menu in the receiver for masking the alert commands depending on their type, seriousness and also depending of a time window. For example:

**TABLE 5**

| **Type of alert command** | **Seriousness level** | **Personal configuration of a receiver (30)** | **Changed allowed by the listener** |
|---|---|---|---|
| I | A | Time window (for example: 9.00 to 20.00) | Mode 1 |
| | B | Always | Mode 2 |
| | M | Never | - |
| II | A | Time window (for example: 7.00 to 23.00) | Mode 2 |
| | B | | |
| | M | Never | - |

There should also exist non-maskable alert commands, for really exceptional events.
- "Ticker" line: part of the area of display (24) will be used for showing relevant contents for anybody or for a special group of receivers (30), whenever the display (24) is active (Modes 1 or 2), provided the user is not browsing through the information menus using the knobs (29) nor the display (24) is dedicated to any particular use. The movement on the ticker line will be useful for picking up the attention of the user, and also as an stimulus for using the navigation.
- Link lines: The capacity for storing information in the receivers (30) is limited to the size of their memories (22) and its mass storage device (90). Accordingly, the user should be referred to another information source (such as an Internet address) when large amounts of information are required. As a general rule each element of the information menu is formed by: a context line (or headline), the content itself and one or more link lines (hyperlinks). This scheme helps the user to profound into any content without performing a search step. There are 3 possible procedures to be implemented: a) The user types in the characters of the hyperlink into an Internet browser, b) the receiver (30) contains an interface -could be a wireless interface- for connecting to a personal computer, a digital television or other device; when the user press a key on the menu then some signals are sent containing the hyperlink information, and c) the subsystem (28) of receiver (30) is a set of digital cellular telephony which allows to access into mobile portals (GSM, WAP, GPRS, CDMA, UMTS, etc.) where the required information is obtained.

The display device (24) is a good medium for showing text or graphic messages, which can be very useful for backing the radio programmes, for example sending the name of the commentator, its photograph, the song's title, etc. It is possible to show single screens or even sequences formed of several screens, which might be synchronized with:
- Other visual effects produced by an optic signalling device (92), as a LED matrix,
- Sound produced by a sound file processor (93), and amplified at the audio amplifier (14) for being delivered through the speaker or speakers (15),
- Sound effects generated by a buzzer device (91),
- The audio signal of one of the teleconfigurable channels (in this case a system for synchronizing the sound signals generated in the different radio studies involved in the creation Channel Offer and the manager of the data channel of the System is required).

To overcome the limitations in bandwidth of the data channel, it is recommended to use animation files, which should be stored in memories (22), (23) or in a mass storage device (90), such as a hard disk drive. These animation files should contain a track or sub file for each peripheral involved in the animation, with appropriate time references for all tracks. Then a simple invocation command specifying the right file sent through the data channel would provoke the execution of the animation file in part or in all the receivers (30). The display device (24) can also be used as an advertisement medium that may be commercially exploited using different advertisement formats, including multimedia capabilities when combined with the said sound elements.

In spite of its impact over the cost of the receiver (30), the use of a subsystem (28) for connecting to the public telephony net gives chance to a huge number of applications that may enrich the experience of listening to the radio, thus enlarging the loyalty of radio listeners. It is specially interesting the case in which subsystem (28) is a set of circuits for digital cellular telephony, since they can easily be used for sending digital data through different protocols (SMS, WAP, MMS, GPRS, etc.). Any information being sent through the data channel of the System explained in the present invention can be send to any subscriber of a digital cellular telephony company, for example using one or more SMS messages. However this method is slow and expensive. The "Cell Broadcast" technique described in Part VIII (State of the Art) is more adequate for this purpose, but there are several limitations: the terminals must be compatible with it, and they have to be enabled accordingly by the user. Second: some messages are lost since Cell Broadcast protocol does not involve delivery confirmation. Third: the messages sent using Cell Broadcast can only reach the subscribers of one telephony operator. Fourth: the available bandwidth for Cell Broadcast is really reduced, since this application must compete with other more profitable applications proper of cellular telephony. In summary, many people cannot be reached by Cell Broadcast: those subscribers of a company whose terminals are not compatible with Cell Broadcast technology, those whose terminals haven't been properly enabled, those whose terminals have been turned off or are out of coverage, subscribers of a different company and those who do not have a mobile phone.

Moreover, most mobile subscribers use to reject advertisements in their terminals, since they do not consider it proper for a paid service; present laws supports this position and they are changing quickly to become more restrictive, due to the development of "spamming" techniques in the modern Information Society. Accordingly, the display device of mobile telephones cannot be easily used as an advertising medium. This is just a derivative of the original conception of telephonic systems, which are intended for a one to one communication where privacy is a basic concern. In contrast, transmission based on conventional radio (or digital radio) is completely open and tends to diffuse their contents as much as possible.

These are some applications that can be implemented into the System:
- Any message, screen or animation received from the data channel of the System can be converted to an adequate format and then being sent through the said subsystem (28) using a coding and sending subprogram. This said subprogram would allow sending certain kind of contents to users of mobile phones or to other types of terminals.
- The operator of the System or the broadcasters involved may be interested in organizing polls in order to know the acceptance of their products/services. A poll can be placed in a subdirectory of the menu and the users interested on attending will be encouraged to select an answer for each question. Each question can be easily answered and sent through the subsystem (28) by means of a subprogram for selecting and sending answers. If each answer is properly coded, the questionnaires can be processed very quickly. As soon as each answer is generated from a known phone number, it is possible to relation the received answers with the user's personal data, in order to check if the poll satisfy the stratification criteria required for being statistically valid. This service can also be offered to commercial research entities.
- The link line described before may also be a telephone number to ask for information. The telephone number could be automatically dialled by a subprogram which would pass the digits to the subsystem (28) for dialling them as soon as the user desires this to be done.
- The users can also use the device for browsing Internet portals intended for mobile phones. A subprogram for jumping from the menu to browsing using the subsystem (28) is required, as much as any type of signalling (since browsing through subsystem (28) use to be non-free).
- Combined technology chats: participants would send messages to the control centre (45) in real time using the subsystems (28) -or from other sources. These messages are also processed in real time and then broadcasted through the data channel to be grouped in a particular subdirectory of the menu.
- The data channel can also be used for sending some files for configuring or customizing certain elements of the subsystem (28), such as the ring tone. Conversely, the subsystem (28) could be used for adding some contents to the menu. The subsystem (28) could even be used for updating the control program of the receiver (30), once authenticated and processed by means of an appropriate subprogram for decoding information.
- As far as there are many types of interferences that can modify the information sent through the data channel, the subsystem (28) can be used for sending back to the control centre (45) the information received at several receivers (30) properly placed, thus giving a feedback loop to the control centre (45). This application may inform about the quality of the transmissions. It could also be exploited commercially for providing advertising reception reports to advertisers, instead of the mere transmission reports commonly used in this sector.

The elements used for generating sound in the receiver (30), such as the audio amplifier (14) and the speaker or speakers (15) might be used for implementing a hands-free function for the subsystem (28), whenever is included a subsystem (96) with one or more microphones, analog to digital converters and a signal processor.

### Description of figures.-

Figure 1 refers to the control centre (45) linked through Internet to the set of master broadcast stations (60) which send digital coded information to the receivers (30) in each region (70) in which the System is in operation.
Figure 2 shows a region (70) which is covered by a set of radio broadcasting transmitters (50), one of each (60) is a master broadcast station. There is also a set of teleconfigurable receivers (30), which are remotely configured from the master broadcast station (60).
Figure 3 refers to a block diagram of a master broadcast station (60) with access to Internet (the plot corresponds to the case of a frequency modulation transmitter).
Figure 4 refers to the parts of a teleconfigurable receiver (30).
Figure 5 refers to a block diagram of a teleconfigurable receiver (30).

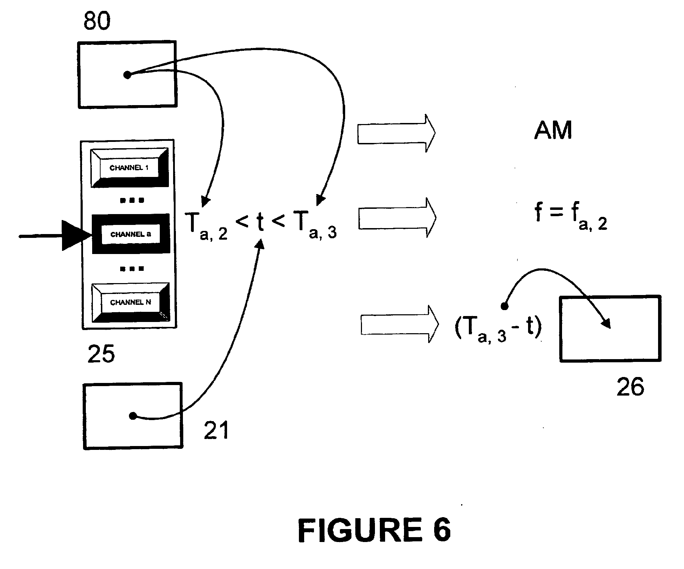

Figure 6 refers to the selection of a compound channel: when the user selects it, some controls have to be adjusted in order to receive the correct signals in the corresponding band, other controls have to be changed for adjusting the receiving frequency inside this band, the calculation of the time intervals during which that tune is enabled (the input data are the actual time and the information stored into the configuration table (80)), and the activation of a timer to measure the remaining time during which the actual tune must stay enabled.

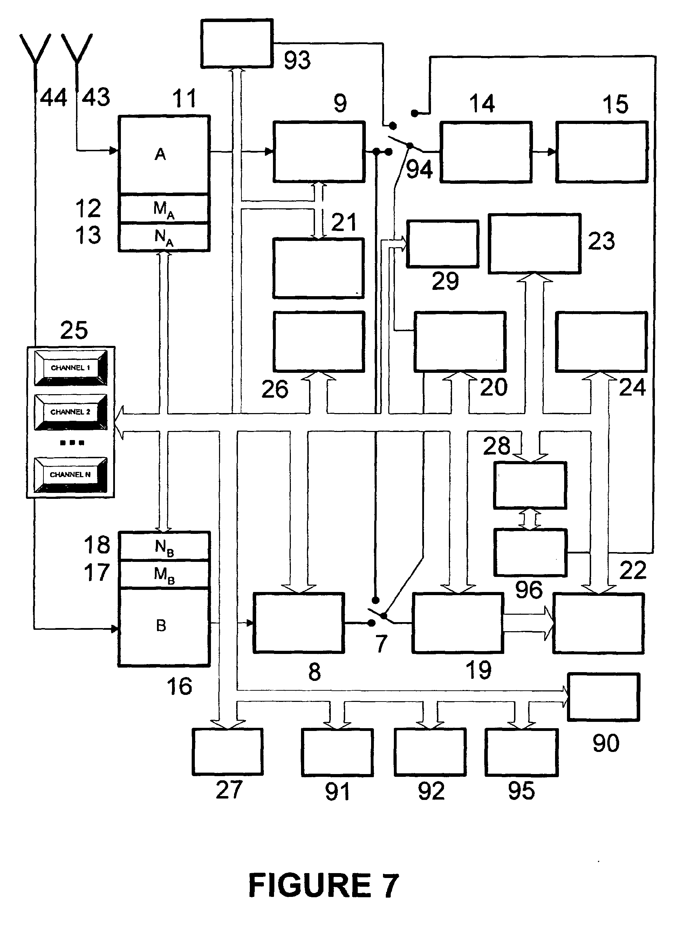

Figure 7 refers to a block diagram of a teleconfigurable receiver (30) in a more complex embodiment.

### Marking list for figures.-

1. Control computer.
2. Encoder for coding digital information according to RDS system.
3. Audio source.
4. Modulator.
5. Transmitter.
6. Transmitter antenna.
7. Toggle switch.
8. Demodulating stage of the data section (41).
9. Demodulating stage of the audio section (40).
11. Digitally controlled tuner for the audio section (40).
12. Prescaler (frequency divider) of tuner (11).
13. Main frequency divider of tuner (11).
14. Audio amplifier.
15. Speaker or speakers.
16. Digitally controlled tuner for the data section (41).
17. Prescaler (frequency divider) of tuner (16).
18. Main frequency divider of tuner (16).
19. Digital data decoder.
20. Controller.
21. Real-time clock.
22. Readable/writeable memory.
23. Permanent memory.
24. Display device.
25. Channel selector.
26. Timer.
27. Regular tuning controls.
28. Subsystem for accessing the public switched telephone network or another public network.
29. Navigation controls.
30. Receiver.
40. Section of receiver (30) for recovering the audio signal of broadcasting frequencies (audio section).
41. Section of receiver (30) for recovering the coded digital data (data section).
42. Control system of the receiver (30).
43. Receiving antenna (or antennas) of the audio section (40).
44. Receiving antenna (or antennas) of the data section (41).
45. Control centre for the operator of the System.
46. Internet.
47. Server for accessing to Internet.
48. Server for accessing to the public switched telephone network or another public network.
49. Public switched telephone network or another public network.
50. Set of radio broadcasting transmitters.
60. Master broadcast station.
70. Region covered by the set of transmitters (50).
80. Configuration table for the channels.
81. Channels of each receiver (30).
82. Time intervals during which a channel (81) corresponds to a frequency (84).
83. Radiofrequency band.
84. Radio broadcasting frequencies corresponding to a channel of receivers (30) during some time interval.
90. Massive data storage device.
91. Buzzer device.
92. Optic signalling device.
93. Processor for converting sound files into analog audio signals.
94. Audio source toggle switch.
95. Communications interface.
96. Subsystem for hands-free function.

### Embodiment of the invention:

First of all, it should be noted that, as a consequence of the technical development and the subsequent national and international regulation changes, the commercial radio broadcasting experienced a development on different frequency bands. Likewise, and due to the same reasons, different modulation techniques (as the amplitude modulation and the frequency modulation), different coding techniques (analog and digital) and different coding formats for digital techniques have been used. All of it is related to sound broadcasting, as it is intended to communicate a sound by means of herzian waves. Continuous technological improvements have evolved bringing new ways for transforming the sound before transmitting it, despite all the transformations should be reversed after the reception of the waves, always looking for practical advantages as better sound quality, less radiated energy for the same coverage area, or slighter influence from interferences and atmospheric conditions. This statement applies to all the aforementioned systems, even those for digital radio broadcasting. The latter, more flexible, can be used even for low resolution video transmission and text. For this reason, regardless of the system considered, there are always common elements like the antenna for picking up the radiofrequency signals (although its specifications and physical appearance may be varied), the radiofrequency amplifier or the audio amplifier at the output which raises the power level of the retrieved signal for driving the speakers. Besides, there are other elements and specific circuits depending on the frequency band, the modulation technique, the coding technique, the format adopted, and so on. Nevertheless, these elements play corresponding roles when retrieving the information from the broadcasted radio signal. Unlike other technical fields where technical improvements give rise to new products quickly and definitely replacing the previous ones, in the world of radio broadcasting the different technologies coexist nowadays due to acquired rights of broadcasters and users, and due to the shortage of the radio electric spectrum. The inventive concept proposed is inde**pendent of the frequency band, the modulation technique, the coding technique and the format adopted**. These subjects belong to the state of the art, and as the vocation of the device is to be in service of radio broadcasters, it should be adapted to the required technique and operational band in which the later operate, what, combined with the different receiver technologies in use give raise to a wide range of possible embodiments to be taken into consideration. Their description will be done starting from the super heterodyne receiver block diagram, provided it is the reference scheme for sound radio broadcasting. It should not be considered as a limitation, as it is well known that there are equivalent schemes on the state of the art from the point of view of the signal extraction, i.e., those based on direct conversion (so called because the transmission band is directly moved to the audio band, without intermediate frequency stages).

A preferable embodiment of the invention is now explained. This embodiment is useful for being produced and commercialized and is easy to be understood. It contains two tuners: one for audio and another one for data. Digital data is transmitted through RDS System, using two ODA services specifically defined for this application (for an explanation of the ODA services, please refer to State of the Art, Part IV).

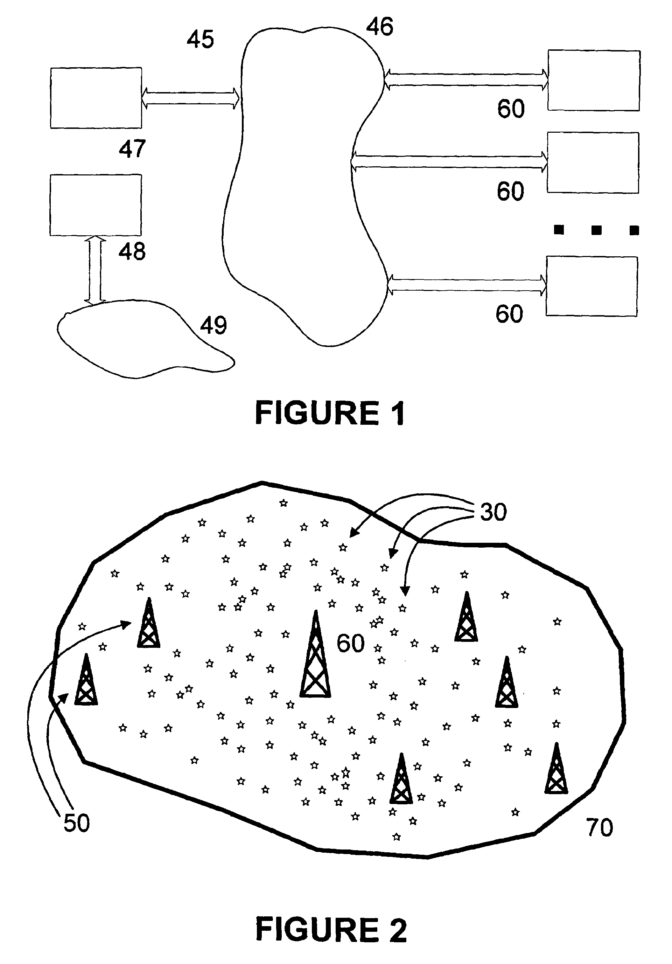

The System is formed (figures 1 and 2) by:
A control centre (45) for the System,
A set of regions (70) in which the System is operated,
A set of radio broadcasting transmitters (50) operating in each region (70),
A set of master broadcast stations (60), each one operating in each region (70), and
A set of radio receivers (30) spread inside the regions (70).

A complete description of the transmitters covering each region (70) is stored in a database which is available at the control centre (45) of the System. This station is in charge for determining the channel offer that must correspond to each receiver, for each region (70). The control centre (45) is connected to each master broadcast station (60) through Internet, using the server for accessing to Internet (47), o by any other mean, as the satellite connexion.

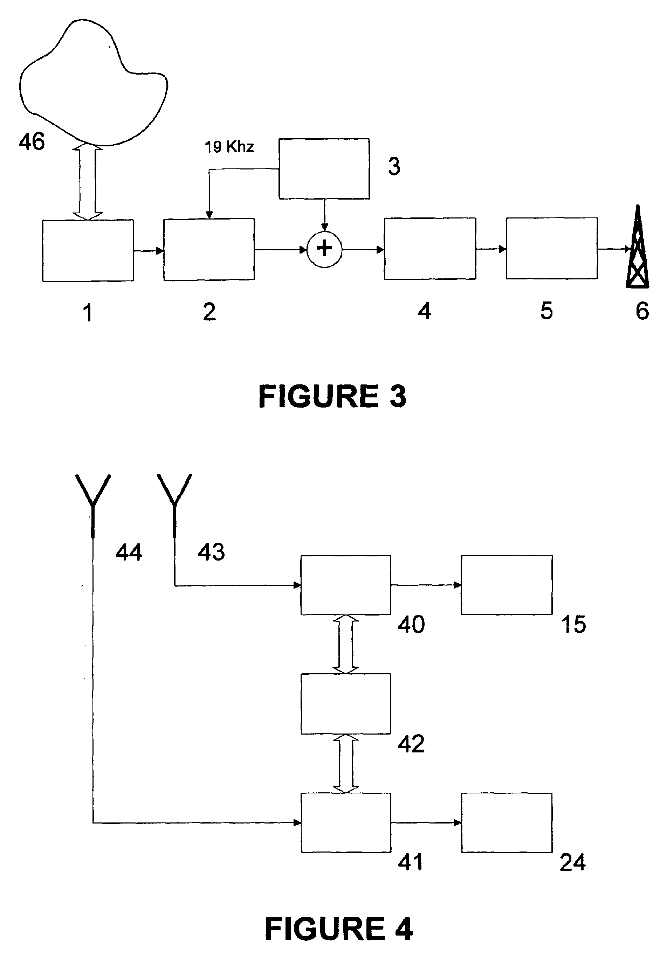

Each master broadcast station (60) emitting in the frequency modulated band has been assigned a frequency f_{MA} in the region (70). This transmitter, figure 3, contains a control computer (1), an encoder (2) compliant with RDS requirements, an audio signal source (3), a modulator (4), a transmitter (5) and an emitting antenna (6). The codified data is modulated with the audio signal (coming from the audio signal source) inside modulator (4), which feeds the transmitter (5) and then the antenna (6).

Each receiver (30), figure 5, contains two tuners A (11) and B (16) controlled by PLL. Tuner A (11) is tuned to frequency f_{A} as determined by its frequency divider N_{A} (13) of its PLL loop, in the frequency band determined by the frequency divider or prescaler M_{A} (12). Tuner A (11) feeds the demodulating section (9), which recovers the audio signal, then the amplifier (14) amplifies its level for moving the speakers (15). On the other hand, tuner B (16) is tuned to frequency f_{B} as determined by its frequency divider N_{B} (18) of its PLL loop, in the frequency modulated (FM) band. Tuner B (16) feeds the demodulating section (8), which recovers the RDS signal contained at the FM multiplex at the frequency f_{B} , then the decoder (19) extracts the digital information.

Frequency dividers M_{A}, N_{A} and N_{B} are set by the controller (20), which commands the operation of the receiver (30).

Each receiver (30) contains a real-time clock (21) which is maintained in time by means of the CT service, which will have to be included into the RDS frame (for an explanation of the CT service, please refer to State of the Art, part IV). Master broadcast station (60) will send a CT code each time the minute changes. Toggle switch (7) is commanded by the controller (20) and makes possible to obtain the RDS general information (as the name of the chain tuned) that might exist at the frequency received by tuner A (11), using the decoder (19), thus recovering the RDS information of the channel that is being heard. (This can also be accomplished changing f_{B} during a brief interval, to the value of f_{A}; the time required for getting the static RDS information is very short, as it was explained in Part III, State of the Art).

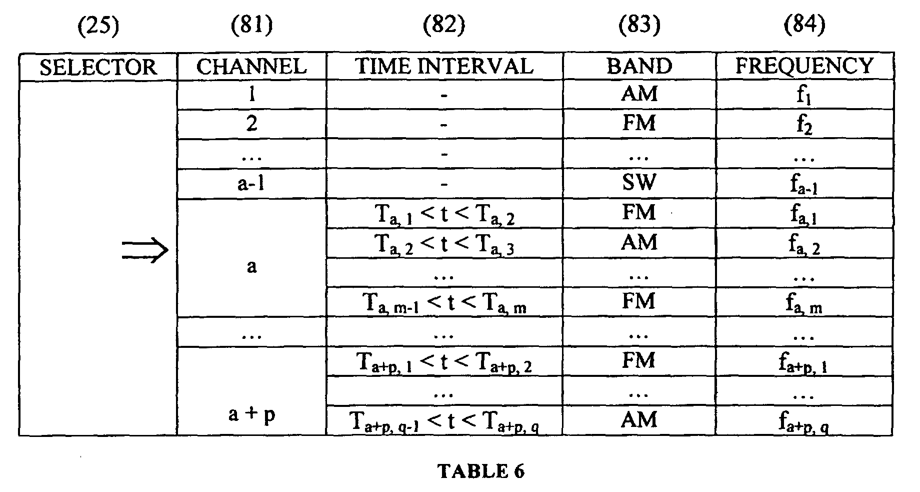

There is a space in the memory (22) of the receiver (30) reserved for storing a configuration table (80) as shown schematically on table 6. In this configuration table (80) is stored the frequency (84) and the band (83) corresponding to each channel (81), as much as the time interval (82) of validity for compound channels. For simple channels (those whose equivalence between channel and frequency is not time dependent), a code is stored for avoiding time verifications.

The program executed by the controller (20) is able for interpreting the protocol of the ODA applications AID-1 and AID-2 that have been created for the present invention. Service AID-1 is intended for sending configuration information, whereas service AID-2 is used for sending the remaining information (news and so on). It is possible to use a unique service and differentiate both types of information (configuration and the remaining), but since the refreshing requirements of both types of information is really different, it is easier to manage it with two different services, according to RDS philosophy.

Now it is explained the operation of the System from the user's point of view, using figures 4 and 5:
When the listener of a receiver (30) selects a channel (channel a in the figures) using the channel selector (25), the controller (20) verifies:
   The real-time clock (21), and
   The configuration table (80) contained in memory (22).

From the configuration table (80) it is obtained: the frequency (84) (f_{a,2} in the figures) and the band (83) (AM, in the figures) to which tuner A (11) must be tuned in that moment (t, in the figures). The controller acts over the required tuning controls (see page 9) so that the tuner gets tuned to the frequency specified in the table.

For compound channels the controller calculates the remaining time for the active frequency, subtracting the hour (obtained from the real-time clock (21)) from the end hour specified for that frequency in the configuration table (80). The difference between these values is stored in timer (26) (in the figures, T_{a,3}-t). Once this time-out is reached the timer (26) generates an interruption for the controller (20), meaning that the active tune must be changed to the following frequency (f_{a,3} in the figures). The controller (20) will automatically command the required tuning controls (see page 9) in order the new frequency may get tuned.

Most high quality commercial radio is created live, then clashing timetables. This effect will produce sudden tune changes in compound channels which will probably bother the listener. There are several ways for avoiding this problem. As they are not relevant for the proposed invention, they are explained as examples. If both the finishing and the beginning programmes belong to the FM band, they can implement the PIN service as defined in RDS for a precise switching of frequencies (please, refer to State of the Art, Part IV for an explanation of this service). If the finishing programme is delayed, tuner B (16) may be tuned to the frequency of the beginning programme, to watch for a possible delay in the beginning time. Be that the case, the listening of the finishing programme can be automatically extended. When the beginning programme were to initiate, tuner B (16) would receive the change in PIN code, thus an interruption for the controller (20) should be generated; the controller then would change the frequency of tuner A (11) to the new value as established on the configuration table, and tuner B (16) will come back to the master frequency (provided it might be acceptable for the System's operator a brief interruption of the data channel). The precedent solution cannot work if both programmes are overlapped, since only one of them can be heard at a time. There are several ways for solving the event, which are not relevant for the present invention. For example: a hard switching between frequencies can be used, but then the listener may press a key for extending the listening of the finishing programme. Extensions of two minutes could be asked for up to three times (for example). The duration of these extensions and the number of them that could be piled up are two parameters of the control program executed by the controller (20) of the receiver. This method is more general than the other one explained before, since it can be used in any case: it doesn't require that both the finishing and the beginning programmes belong to the FM band, nor they use the RDS system nor the involved broadcasters implement the PIN service.

The contents manager is the key stone for the channel offer, since he must decide the frequency to be assigned to each channel (case of the simple channels), and the assortment of frequencies to be assigned to each compound channel. The control centre (45) is the tool for managing the channels of the receivers in each region in which the System is in operation. The configuration information for the receivers (30) is introduced and formatted in the control centre (45). The corresponding information -which is region dependent-, is then sent to each master broadcast station (60) through Internet (46) where it is delivered to the RDS encoder (2).

The said configuration information is periodically sent through the data channel to the master broadcast station (60) using the RDS system. A specific ODA service which we call AID-1 has been created for this purpose (please, refer to State of the Art, Part IV for a description of ODA services). This information is received at tuner B (16), then it is recovered at the decoder (19) and finally it is correctly interpreted by the controller program, which will store it in memory (22).

When the receivers (30) are turned on they have to execute an initializing cycle for finding the master broadcast station in the FM dial which is stated below. The FM dial must be scanned with Tuner B (16), for comparing the PI code of each RDS enabled station with a code that is stored in the permanent memory (23), which identifies the master broadcast stations (please, refer to State of the Art, Part IV for a description of PI service). The scan must proceed until the frequency f_{B} to which tuner B (16) is tuned corresponds to the master frequency f_{MA} used by the System in region (70), i.e. until f_{B} = f_{MA}. If the System has got alternative frequencies in a region, it will be notified in accordance with the RDS standard; tuner (B) will be tuned in turn to each alternative frequency, in order to evaluate the signal quality of each alternative frequency, as it is usually performed by RDS receivers. As the receivers are permanently (or almost permanently) engaged to the data channel, the initializing cycles will only be required when the engagement is lost during a non negligible time interval; for example if the receiver is out of the master broadcast station coverage area, if the receiver is moved out of the coverage area or when it gets unenergized.

It might happen that the receivers were to be used in regions in which the System lacks of transmitters. In such case the System's operator will have to reach a kind of arrangement with other broadcasters in order they render the data services to the receivers (30) (for example, hiring an under used RDS subcarrier). In order to make it possible the receivers should have stored in the permanent memory (23) an ordered list of admitted PI codes for providing data services. Accordingly the initializing cycle would now begin with tuner B (16) scanning the FM dial, searching for the first admitted PI code of the list, then the second one, and so on until it would find an admitted PI code of the said list, if ever. Otherwise, the receiver should try to find the master frequency periodically, since the receiver needs a permanent link to the data channel in order to be fully functional.

The optimal operation of the data channel requires that tuner B (16), the demodulating section (8), the decoder (19), the controller (20) and the memory (22) be continuously running, regardless the user listens to the radio. Be that the case, the operator of the System may send much larger amounts of information through the data channel, since the need for repeating information is reduced to the minimum fixed by the technical limitations of the FM subcarriers. Moreover, this pattern for sending the information ensures that the information in any receiver is always up to date. Due to it, the associated broadcasters can also reduce the repetition rate of audio programmes, thus being of help for making the programming more attractive and improving the efficiency of the audio channels.

Though the teleconfigurable receiver may host a large channel offer, it can make sense to include regular tuning controls (27) for tuner A (11). These controls will always actuate through controller (20) of the receiver, in order to preserve the handling of the receiver for the control program. On the other hand tuner B (16) will be kept tuned to the master frequency for optimizing the receiver's functionality.

Besides the configuration information -which is sent to all the users of the System- the remaining information may belong to one of these categories:
1. Common information, addressed to all the users of the System in a region.
2. Groups information, addressed to groups of users of the System, and
3. Personal information, which is addressed to a single receiver of the System.

Accordingly, each receiver only contains just a part of the total information in spite of all the information being transmitted at a time. Each receiver has got:
1. A unique code, which makes it different from the other receivers. This code makes possible to separate the text messages addressed to that single receiver (and discard the messages addressed to any other receivers), in accordance with provisions done for the RDS System.
2. A group code, which makes possible to separate the text messages addressed to that group code (and discard the messages addressed to other groups of receivers). The communication protocol AID-2 allows adding a group code to each piece of information. Besides, the System's operator knows the different groups and formats this information specifying the listener's to which it is addressed.

Another embodiment which is simpler and cheaper is obtained if the following sections are not mounted: the tuner B (16), the demodulating section (8) and the toggle switch (7). There would remain: the tuner A (11) and the demodulating section (9), which would then feed the decoder (19) and the audio amplifier (14). Since there is only one tuner, it should have to be tuned to the master frequency during some time intervals, and it will no longer be possible to listen to a frequency other than the master frequency and receive the data channel at the same time. The remaining time the tuner could be tuned to any other teleconfigurable channel or even to any frequency, provided the receiver contains regular tuning controls. Due to the non permanent link to the data channel there is a great reduction on data channel's efficiency, and some advantages due to the permanent connexion are also lost. These disadvantages can be partly mitigated if all the receivers connect to the master frequency at least during a given time interval. For example, if all the receivers are tuned to the master frequency from 2.00 to 6.00 AM (the time interval of minimum radio audience), then there are a minimum of 4 hours of daily connexion, allowing for sending the configuration information and much more information. During the forced connexion to the master frequency, the user can only listen to the audio signal of this frequency; the channel selector (25) and the regular tuning controls (27) (if any) should stay disabled, in order to ensure the connexion during the programmed time interval. Besides this time interval, the tuner A (11), the demodulating section (8), the decoder (19), the controller (20) and the memory (22) will connect to the data channel anytime the user is not listening to the radio, in order to update the information as frequently as possible. Obviously, the initializing cycle for finding the master frequency will be performed with tuner A (the unique one in the receiver); accordingly, no audio programme can be listened to during the initializing cycle.

In order to include the audimetric function for the receivers, it must be stored in memory (22) the date and time at which the listener selects each frequency with the receiver, and the date and time at which he enters into any menu shown in the display device (24), and the duration of each access. With these records the control program have to produce a file for being send to the server (48) of access to the public switched service network, placed at the control centre (45). The file must include the individual code of the receiver, in order to identify the information sent by each user. The information is sent using the susbsystem (28) for accessing to the public switched service network, which can be a fixed modem or a set of mobile phone circuits.

The following paragraphs explain the problem that arises because of the use of a single display device (24) with a multiplicity of remote configurable channels and the way to solve it. As it was pointed in the Description of the Invention, the display (24) allows a combined use, during a time lapse, with the audio received via one of the remotely configurable channels, thus producing multimedia animation. In the case of advertising functions, it could well happen that while showing an advertisement animation on the display a sound advert of a different announcer might be launched through any of the remotely configurable channels. To avoid such unwanted coincidence two different strategies have been developed; they are described as follows. Both strategies or methods are not unable to coexist; on the contrary the System's operator must decide which one should be more suitable in each case, depending on the number of remotely configured channels in a particular region (70), the total amount of sound advertisement managed in those channels as well as the number of visual impacts to be showed on the display (24):
1. Turn coordination method. It is controlled by the System's data channel manager and it is suitable when the number of channels to be managed is undersized and when the total amount of advertisement to be transmitted through those channels and the visual impacts to be shown allows a non simultaneous announcement. To place an ad on a particular channel a permission order must be requested to the System's data channel manager by telematic means. The manager will alternatively allow the transmission of the different ads according to an established criteria, therefore only one remote configurable channel may transmit publicity adverts, (either sound or multimedia), at a time. In case of multimedia advertisements, such telematic procedures allow the coordination of the sound ads together with an invoke command in order to synchronize both, sound and image, on the receiver (30). Once the manager has authorized taking turns, the channel may proceed with the advertisements, something that must be conveniently reported to the System's data channel manager from the radio studios. Likewise, the end of the advertisement transmission must be reported, therefore leaving a spare turn until a new request is forwarded. While any channel is transmitting advertisements, the data channel manager does not send invocation commands nor animations not linked to sound ads, in order to avoid discoordination of sound and visual publicity of different announcers for the audience of any channel. The data channel manager may send invocation commands or independent animations during the lapse of a spare turn.
2. Receiver uncoupling (disengagement) method. Using this procedure, every radio studio will transmit a warning signal to the System's data channel manager before broadcasting the sound ad at a fixed time lapse (for example, one minute) to allow time to finish an eventual animation on course; likewise a similar warning signal is transmitted once the sound ad is over. These warning indicators are grouped to form an advertisement status vector signal, which is sent to the set of receivers involved via the data channel. This vector signal is updated every time there is a mode change. Each radio station control may transmit sound ads directly, without "requesting a turn" to the System's data channel manager. Such permission order needs only be requested when a synchronized sound ad with its corresponding visual animation is required as there is only one data channel shared by all the receivers (30) on the same region (70). Once the turn is endorsed, the synchronized sound ad may be transmitted. If a receiver (30) receives an invocation command corresponding to the channel that is being listened at that moment, the specified animation is displayed. If the command corresponds to a different channel or is independent of the sound channels, before activating the command, the advertisement mode of the channel that is being listened then is verified. In case no sound advertisement is being sent on that same channel, or if the audio is temporarily disabled (on the receiver), the control programme of the receiver allows the specified animation to be shown on the display. On the contrary, if a sound ad is being transmitted through the channel that is being listened, the invocation command is queued in a pending invocation command record until the transmission of sound advertisements is through in that particular channel. Once this transmission is over the pending invocation commands are activated in the same order they were received. Should there not be enough bandwidth available to transmit the advertisement status vector signal with the required precise periodicity, an equivalent signalization method may be implemented by adding a binary signal within the sound signal of every channel, provided it should be inaudible, which would inform whether ordinary programming or advertisement is being transmitted. A specific circuit in the receiver would detect the value of this binary signal, thus it would be capable of managing the activation of the invocation commands according to the procedure explained above.

## Claims

1. System of emitters and remotely-configurable devices that are used to capture a radio audience and to establish loyalty in relation to said audience **characterized by** the following:
■ It provides the system's operator with a control centre (45) supplied with the means needed in order to send digital coded information to every master broadcast station (60) in every region (70) in which the system operates.
■ Each of the said master broadcast stations (60) has a carrier frequency assigned f_{MA}.
■ Each of the said master broadcast stations (60) provide the means needed in order to create a new signal combining the said digital coded signal with other signals for which they are licensed (such as audio signals), as well as the means needed in order to modulate and broadcast the combined signal at the f_{MA} frequency.
■ The remotely-configurable devices that are used to capture a radio audience and to establish loyalty in relation to said audience (30) are receivers equipped with the means needed in order to recover the digital coded information broadcast by the said master broadcast stations (60).
■ The said receivers (30) are equipped with the means needed in order to achieve the uninterrupted reception of the said digital coded information.
■ The said receivers (30) are remotely configured through the said digital coded information.
■ The said receivers (30) provide a variety of channels which may be selected by the user operating a selector (25).
■ The said configuration consists on the allocation of any radio frequency for any time interval and for each of the selectable channels, allowing any of the radio stations broadcasting in the region (70) to be allocated in the said selectable channels of the said receivers (30) available in such region.
■ The said digital coded information contains other data besides the configuration data, which is intended to be displayed in a display device (24).

2. System of emitters and remotely-configurable devices that are used to capture a radio audience and to establish loyalty in relation to said audience, according to claim I, **characterized by** having the said receivers (30) the following:
a. An audio section (40) dedicated to recovering the audio broadcast signals, which include, among other elements, a digitally controlled tuner (11).
b. A data section (41) dedicated to recovering the said digital coded information, which includes, among other elements, a digitally controlled tuner (16).
c. A control system (42) which executes a control program and manages the device's operation.
d. A device identification digital code that is stored in the non-volatile memory (23) and which identifies uniquely each de-vice.
e. A group identification digital code that is stored in the non-volatile memory (23) and which identifies uniquely each group of devices.

3. System of emitters and remotely-configurable devices that are used to capture a radio audience and to establish loyalty in relation to said audience, according to claims 1 and 2, **characterized** for integrating the said section (40) dedicated to recovering the audio radio broadcast signals in the said receivers (30) the following:
a. A multi-band tuner (11) digitally commanded by the controller (20).
b. A demodulator section (9) capable of recovering the audio signals broadcast in different bands, modulations, codifications and formats used in analogue and/or digital radio broadcasting.
c. An audio amplifier (14).
d. One or several loudspeakers (15).

4. System of emitters and remotely-configurable devices that are used to capture a radio audience and to establish loyalty in relation to said audience, according to claims 1 and 2, **characterized** for integrating the said section (41) of the receivers (30), which is dedicated to recovering the said digital coded information, the following:
a. A multi-band tuner (16) digitally commanded by the controller (20) and the means needed in order to preserve it tuned at the frequency f_{MA} which is assigned to the master broadcast station of region (70) in which is located the said receiver (30).
b. A demodulator section (8) capable of recovering the data signal broadcast by the master broadcast station (60) in the band in which it operates, under the coding and format that may correspond, in case the master broadcast station (60) is a digital radio broadcast station.
c. A decoder circuit (19) that is capable of recovering the said digital coded information, that has error detection and correction built-in circuits according to the data format used by the System's operator.
And because of the following:
■ The said digital coded information is stored in memory (22).
■ The receivers (30) are equipped with navigation controls (29) which provide the users with access to the said digital coded information stored in memory by the use of a display device (24).
■ The said section (41) of the receivers (30), as well as the means needed in the said section (42) of the receivers (30), operates uninterruptedly so that all the said digital coded information is stored in memory (22).

5. System of emitters and remotely-configurable devices that are used to capture a radio audience and to establish loyalty in relation to said audience, according to claims 1 and 2, **characterized** for integrating the said control system (42) of the receivers (30) the following:
a. A control circuit (20).
b. A control program.
c. A real-time clock (21) which is always accurate due to periodical synchronizations with clock signals contained in the said digital coded information.
d. A memory (22) in which the said digital coded information is stored.
e. A reserved space in memory (22) left to store the said information regarding the configuration of the said channels available in the receivers.
f. A timer (26) used in order to determine the validity time left for the channel in use, when appropriate.
g. A control key which enables the user to extend the validity time for the channel in use when it ends, the means needed in order to time the new extension applied and the means needed in order to count the number of successive time extensions that have been applied for the channel in use.
h. A non-volatile memory (23) in which the following is stored:
i. Certain digital codes that allow the identification of the master frequencies in every band in which they may broadcast according to the technique used by the master broadcast station (60) in every region (70) for the broadcasting of the said digital coded information.
ii. The receiver's said device identification digital code.
iii. The receiver's said group identification digital code.
i. The means needed so that the receiver may perform an initialization cycle in which the tuner (16) will seek for the master frequency that may be available in the region for every band in which it may be found, every time the connection with the master broadcast station is lost for a significant period of time.

6. System of emitters and remotely-configurable devices that are used to capture a radio audience and to establish loyalty in relation to said audience, according to claim 1, **characterized by** the following:
■ Preferably each of the master broadcast stations (60) is a frequency modulated (FM) broadcast station which contains an information encoder (2) compatible with the RDS system, an audio signal source (3), a modulator (4), a transmitter (5) and a broadcast antenna (6).
■ The master broadcast stations (60) receive from the control centre (45) the digital coded information in an RDS system compatible format through certain means.
■ The said information received is modulated together with the audio signal source (3) through the modulator (4), which feeds the transmitter (5) that broadcasts through the antenna (6).

7. System of emitters and remotely-configurable devices that are used to capture a radio audience and to establish loyalty in relation to said audience, according to claims 3, 4, 5 and 6, **characterized** for containing the protocol used in order to send the digital coded information instructions for sending messages and information:
a. to every single receiver (30),
b. to every single receiver (30) in a specific group, defined by the said group identification digital code,
c. or else to a single receiver (30), defined by the said device identification digital code.
And because of having the said control system (42) of the receivers the means needed to identify and manage the said messages and information received, keeping just those pieces of information and messages which are suitable to the receiver (30) and discarding the remainders.

8. System of emitters and remotely-configurable devices that are used to capture a radio audience and to establish loyalty in relation to said audience, according to claim 5, **characterized** for being preferably used for the said appropriate synchronization signals sent through the data channel, the CT groups defined in the RDS system.

9. System of emitters and remotely-configurable devices that are used to capture a radio audience and to establish loyalty in relation to said audience, according to claim 7, **characterized** for being preferably used for sending messages to a unique receiver, the existing radio-paging protocol defined in the RDS system (RDS-paging).

10. System of emitters and remotely-configurable devices that are used to capture a radio audience and to establish loyalty in relation to said audience, according to claim 3, **characterized** for being preferably used a PLL (Phase Locked Loop) tuner (11) digitally commanded by the controller (20), and also for being the said tuner (11) tuned in the band of frequencies determined by the M_{A} prescaler frequency divider (12) at the f_{A} frequency which is established by its PLL N_{A} frequency divider loop (13).

11. System of emitters and remotely-configurable devices that are used to capture a radio audience and to establish loyalty in relation to said audience, according to claim 4, **characterized** for being preferably used a PLL (Phase Locked Loop) tuner (16) digitally commanded by the controller (20), and also for being the said tuner (16) tuned in the Frequency Modulated (FM) band at the f_{B} frequency which is established by its PLL N_{B} frequency divider loop (18).

12. System of emitters and remotely-configurable devices that are used to capture a radio audience and to establish loyalty in relation to said audience, according to claims 3, 4, 5 and 6, **characterized** for containing a toggle switch (7) managed by the controller (20), which enables for short periods of time the decoder (19) in the data section (41) to get connected to the data output from the demodulator section (9) in the audio section (40) in order to extract the basic RDS information that corresponds to the audio channel tuned in tuner (11).

13. System of emitters and remotely-configurable devices that are used to capture a radio audience and to establish loyalty in relation to said audience, according to claims 3, 4 and 5, **characterized** for having the receivers (30) conventional tuning controls (27) in order to command the controller (20) the tuning of any frequency within the bands that may be received by section (40), as well as the tuning of any of the channels contained within the remotely configurable channel system claimed.

14. System of emitters and remotely-configurable devices that are used to capture a radio audience and to establish loyalty in relation to said audience, according to claims 3, 4 and 5, **characterized** for the following:
■ Sharing the said audio section (40) with the said data section (41) the digitally commanded tuner as well as the demodulator section.
■ At specific time intervals the said shared tuner is unavoidably tuned at the frequency of the master broadcast station (60), remaining inoperative the channel selector controls (25) as well as the tuning controls (27), in case there were such controls.
■ Out from those said specific time intervals, if the user turned off the audio section (40) of the receiver (30), the controller (20) would command the shared tuner to get tuned at the frequency of the master broadcast station (60), resuming the reception and management of the said digital coded information.

15. System of emitters and remotely-configurable devices that are used to capture a radio audience and to establish loyalty in relation to said audience, according to claims 1, 2 and 5, **characterized** for having the said control system (42) of the receivers (30), a PSTN (Public Switched Telephone Network) or other public network subsystem (28) which enables the interchange of information with the system's control centre (45).

16. System of emitters and remotely-configurable devices that are used to capture a radio audience and to establish loyalty in relation to said audience, according to claims 1, 2, 5 and 15, **characterized** for the following:
■ Every time the user activates or deactivates the audio reception, the said control system (42) of the receivers (30) records into memory (22) a register containing a timestamp (actual date and time), the channel selection or frequency tuned and the action performed (activation, deactivation).
■ Every time the user operates a navigational control (29), the said control system (42) of the receivers (30) records into memory (22) a register containing a timestamp (actual date and time), the menus or contents accessed and the duration of the action.
■ The said control system (42) of the receivers (30) organizes every recorded register into a formatted file that is apt to be transmitted and which includes the said device identification digital code.
■ The receivers are able to transmit the said formatted files to the control centre (45) through the external network connection subsystem (28).

17. System of emitters and remotely-configurable devices that are used to capture a radio audience and to establish loyalty in relation to said audience, according to claim 5, **characterized** for integrating the receivers (30) a massive data storage device (90).

18. System of emitters and remotely-configurable devices that are used to capture a radio audience and to establish loyalty in relation to said audience, according to claim 5, **characterized** for integrating the receivers (30) a buzzer device (91).

19. System of emitters and remotely-configurable devices that are used to capture a radio audience and to establish loyalty in relation to said audience, according to claim 5, **characterized** for integrating the receivers (30) a visual signalling device (92).

20. System of emitters and remotely-configurable devices that are used to capture a radio audience and to establish loyalty in relation to said audience, according to claim 5, **characterized** for having the receivers (30) three operational modes:
a. Mode 1, in which all sections in the device are functioning.
b. Mode 2, in which the audio section (40) dedicated to recovering the audio radio broadcast signals and the processor (93) dedicated to converting the digitalized audio files into analogue audio signals are disabled.
c. Mode 3, in which the audio section (40) dedicated to recovering the audio radio broadcast signals, the processor (93) dedicated to converting the digitalized audio files into analogue audio signals and the display device (24) are disabled.

21. System of emitters and remotely-configurable devices that are used to capture a radio audience and to establish loyalty in relation to said audience, according to claims 5 and 20, **characterized** for the following:
■ The receiver (30) allows the user to select the said mode of operation by the use of controls available in the device.
■ The protocol used for the transmission of the said coded digital information contain instructions for sending different types of alert commands which advise or impel the user to change the operational mode to a different one.
■ Some of the said types of alert commands may be masked through a user personalization menu available in the receivers (30).
■ Certain types of the said types of alert commands may not be masked whatsoever.

22. System of emitters and remotely-configurable devices that are used to capture a radio audience and to establish loyalty in relation to said audience, according to claim 5, **characterized** for containing the control program of the control system (42) of the receivers (30) a subprogram dedicated to handling the presentation of the contents residing in a particular subdirectory of the said digital coded information received by the receivers (30), in such way it is presented as a single line of information that moves gently, also called ticker line.

23. System of emitters and remotely-configurable devices that are used to capture a radio audience and to establish loyalty in relation to said audience, according to claims 5 and 17, **characterized** for the following:
■ The protocol used for the transmission of the said coded digital information contains instructions for sending digitalized audio files according to a certain format.
■ There is an audio processor (93) dedicated to converting the said digitalized audio files -stored in the memories (22) or (23) or in the massive data storage device (90)-into analogue audio signals.
■ There is a toggle switch (94) of the audio source that is commanded by the controller (20) which selects the audio output signal that is amplified at the audio amplifier (14) so that it may be heard through the loudspeaker or the loudspeakers (15).

24. System of emitters and remotely-configurable devices that are used to capture a radio audience and to establish loyalty in relation to said audience, according to claims 5, 17, 18 and 19, **characterized** for containing the control program of the control system (42) of the receivers (30) a subprogram dedicated to handling the execution of animations, being in charge of activating simultaneously some or all of the following receiver's (30) peripheral devices:
a. the visual signalling device (92),
b. the buzzer device (91),
c. the toggle switch (94) of the audio source,
d. the processor (93) dedicated to converting the digitalized audio files into analogue audio signals,
e. the presentation of one or more screens with information in the display device (24),
according to an animation file stored in the memories (22) or (23) or in the massive data storage device (90) and also for being able to disable the receiver's (30) navigation controls (29) during the execution of an animation.

25. System of emitters and remotely-configurable devices that are used to capture a radio audience and to establish loyalty in relation to said audience, according to claims 5 and 24, **characterized** for containing the protocol used for the transmission of the said coded digital information, instructions for sending different types of invocation commands, which specify the control program of the control system (42) which animation file should be displayed through the said animation execution subprogram.

26. System of emitters and remotely-configurable devices that are used to capture a radio audience and to establish loyalty in relation to said audience, according to claim 25, **characterized** for containing certain invocation commands which allow specifying that certain animation files should only be executed in those receivers (30) in which certain remotely configurable channels are tuned.

27. System of emitters and remotely-configurable devices that are used to capture a radio audience and to establish loyalty in relation to said audience, according to claim 25, characterized for being available at each of the radio studies where the radio programs are developed for each of the remotely configurable channels that may be selected in the receivers (30) the following:
a. The means needed in order to signalize the beginnings and the endings of each of the radio advertising spaces.
b. The means needed in order to oversee the display device (24) in every receiver (30) -or of those said receivers (30) in which, through any of the said remotely configurable channels, the radio programs that are developed in the corresponding radio studies are received.
c. The means needed in order to request authorization to the System's data channel manager in order to occupy the display device (24) in every receiver (30) -or in those receivers (30) in which, through any of the said remotely configurable channels, the radio programs that are developed in the corresponding radio studies are received,- while the radio advertising spaces last.
d. The means needed in order to synchronize the radio advertising spaces with the sending of the said invocation commands.
And also by the following:
■ The communication protocol used in the data channel contains instructions which state the broadcast condition of the radio advertising spaces for each of the said remotely configurable channels in each region (70).
■ The said control program of the control system (42) of the receivers (30) contains an invocation command discrimination subprogram which enables the execution of the required animations through the corresponding invocation commands only in those receivers in which a certain remotely configurable channel is tuned, and, be that the case, while a radio advertising space lasts, it queues all the other invocation commands that may be received, delaying the execution of the corresponding animations while the said radio advertising space lasts, all in a way that while a radio advertising space lasts no animations from other advertisers will be displayed in the display device (24).

28. System of emitters and remotely-configurable devices that are used to capture a radio audience and to establish loyalty in relation to said audience, according to claim 5, **characterized** for providing the contents available in the said information menus that may be displayed in the display device (24) one or more links or remission lines which enable the user to straightly extend the content by the use of another information provider, such as an Internet web link.

29. System of emitters and remotely-configurable devices that are used to capture a radio audience and to establish loyalty in relation to said audience, according to claim 28, **characterized** for providing the receivers (30) a communication interface (95) which enables the communication with other devices -such as a personal computer connected to the Internet-in order to transfer the said links or remission lines.

30. System of emitters and remotely-configurable devices that are used to capture a radio audience and to establish loyalty in relation to said audience, according to claim 5, characterized for containing the said control program of the control system (42) of the receivers (30) a subprogram in charge of formatting, coding and sending the received contents through the System's data channel to a compatible format suitable to be used in the said PSTN (Public Switched Telephone Network) or other public network subsystem (28).

31. System of emitters and remotely-configurable devices that are used to capture a radio audience and to establish loyalty in relation to said audience, according to claims 15 and 30, **characterized** for containing the said control program of the control system (42) of the receivers (30) a subprogram which enables the user to select one option among several available in a particular information subdirectory and then it sends such selection's relevant information to the System's control centre (45) -or to any other fixed destination- through the said PSTN (Public Switched Telephone Network) or other public network subsystem (28).

32. System of emitters and remotely-configurable devices that are used to capture a radio audience and to establish loyalty in relation to said audience, according to claims 15 and 28, **characterized** for being one or more of the said links or remission lines a telephone number reachable through the said PSTN (Public Switched Telephone Network) or other public network subsystem (28).

33. System of emitters and remotely-configurable devices that are used to capture a radio audience and to establish loyalty in relation to said audience, according to claim 32, **characterized** for containing the said control program of the control system (42) of the receivers (30) a dialler subprogram which enables the user to produce an automatic telephone call -through the said PSTN (Public Switched Telephone Network) or other public network subsystem (28)- to the telephone number specified in the said remission line.

34. System of emitters and remotely-configurable devices that are used to capture a radio audience and to establish loyalty in relation to said audience, according to claims 15 and 28, **characterized** for being one or more of the said links or remission lines a web address to an Internet portal reachable through the said PSTN (Public Switched Telephone Network) or other public network subsystem (28).

35. System of emitters and remotely-configurable devices that are used to capture a radio audience and to establish loyalty in relation to said audience, according to claims 15 and 28, **characterized** for containing the said control program of the control system (42) of the receivers (30) a subprogram which performs the linking to the specified address in the said link or remission line through the said subsystem (28).

36. System of emitters and remotely-configurable devices that are used to capture a radio audience and to establish loyalty in relation to said audience, according to claim 15, **characterized** for providing the System's control centre (45) with the means needed in order to assort in real time the information sent by the said PSTN (Public Switched Telephone Network) or other public network subsystem (28) of the receivers (30) -as well as from other sources, such as Internet- into a file which is kept updated in a certain subdirectory available in the receivers (30) through the System's data channel.

37. System of emitters and remotely-configurable devices that are used to capture a radio audience and to establish loyalty in relation to said audience, according to claim 15, **characterized** for being able to send through the System's data channel a variety of files that may be used to change certain settings of the said PSTN (Public Switched Telephone Network) or other public network subsystem (28) of the receivers (30), such as the ring tone of the said subsystem (28).

38. System of emitters and remotely-configurable devices that are used to capture a radio audience and to establish loyalty in relation to said audience, according to claim 15, **characterized** for containing the said control program of the control system (42) of the receivers (30) an information decoder subprogram which decodes and organizes the information received through the said PSTN (Public Switched Telephone Network) or other public network subsystem (28) of the receivers (30) placing the said decoded information in the corresponding menus of contents or incorporating it into the control program.

39. System of emitters and remotely-configurable devices that are used to capture a radio audience and to establish loyalty in relation to said audience, according to claim 15, **characterized** for sending some of the receivers (30) to the System's control centre (45) the digital coded information that they have previously received, using the said PSTN (Public Switched Telephone Network) or other public network subsystem (28) of the receivers (30) so that the control centre (45) may detect the deviations that there could be between the digital coded information sent by each of the master broadcast stations (60) and the digital coded information that is actually received by some of the receivers (30).

40. System of emitters and remotely-configurable devices that are used to capture a radio audience and to establish loyalty in relation to said audience, according to claim 15, **characterized** for incorporating a hands free subsystem into the receivers (30), so as to maintain telephonic calls through the said PSTN (Public Switched Telephone Network) or other public network subsystem (28) through the audio amplifier (14) and the external loudspeaker or loudspeakers (15).

## Amended claims

### Amended claims under Art. 19.1 PCT

**1.** (Amended).System of emitters and remotely-configurable devices that are used to capture a radio audience and to establish loyalty in relation to said audience **characterized by** the following:
■ It provides the system's operator with a control centre (45) supplied with the means needed in order to send digital coded information to every master broadcast station (60) in every region (70) in which the system operates.
■ Each of the said master broadcast stations (60) has a carrier frequency assigned f_{MA}.
■ Each of the said master broadcast stations (60) provide the means needed in order to create a new signal combining the said digital coded signal with other signals for which they are licensed (such as audio signals), as well as the means needed in order to modulate and broadcast the combined signal at the f_{MA} frequency.
■ The remotely-configurable devices that are used to capture a radio audience and to establish loyalty in relation to said audience (30) are receivers equipped with the means needed in order to recover the digital coded information broadcast by the said master broadcast stations (60).
■ The said receivers (30) are equipped with the means needed in order to achieve the uninterrupted reception of the said digital coded information.
■ The said receivers (30) are remotely configured through the said digital coded information.
■ The said receivers (30) provide a variety of channels which may be selected by the user operating a selector (25).
■ The said configuration consists on the allocation of any radio frequency for any time interval and for each of the selectable channels, allowing any of the radio stations broadcasting in the region (70) to be allocated in the said selectable channels of the said receivers (30) available in such region, which overall makes a Managed Radio Offer System.
■ The said digital coded information contains other data besides the configuration data, which is intended to be displayed in a display device (24).

**2.** System of emitters and remotely-configurable devices that are used to capture a radio audience and to establish loyalty in relation to said audience, according to claim 1, **characterized by** having the said receivers (30) the following:
a. An audio section (40) dedicated to recovering the audio broadcast signals, which include, among other elements, a digitally controlled tuner (11).
b. A data section (41) dedicated to recovering the said digital coded information, which includes, among other elements, a digitally controlled tuner (16).
